# EUROPÄISCHE PATENTSCHRIFT

(11) **EP 4 384 838 B1**
(45) Veröffentlichungstag und Bekanntmachung des Hinweises auf die Patenterteilung: **13.08.2025**
(21) Anmeldenummer: 22751271.2
(22) Anmeldetag: 24.06.2022
(51) Int. Cl.: G01R 33/09, G01R 33/12, G01D 5/14

(54) **UMDREHUNGSZÄHLER UNTER VERWENDUNG MAGNETISCHER DOMÄNENWANDLEITBAHNEN, DIE SCHLEIFENARTIG VERWUNDEN UND IN SICH GESCHLOSSEN AUSGEFÜHRT SIND**
MULTITURN COUNTER USING MAGNETIC DOMAIN WALL CONDUCTORS WOUND IN THE MANNER OF CLOSED LOOPS
COMPTEUR MULTITOUR UTILISANT DES CONDUCTEURS DE PAROIS DE DOMAINES MAGNÉTIQUES ENROULÉS EN BOUCLES FERMÉES

(30) Priorität: 12.08.2021 DE 102021004187
(43) Veröffentlichungstag der Anmeldung: 19.06.2024
(73) Patentinhaber: Horst Siedle GmbH & Co. KG., 78120 Furtwangen (DE)
(72) Erfinder: MATTHEIS, Roland, 07743 Jena (DE)
(74) Vertreter: Pfeiffer, Rolf-Gerd
(86) Internationale Anmeldenummer: PCT/DE2022/000077
(87) Internationale Veröffentlichungsnummer: WO 2023/016593

(56) Entgegenhaltungen:
- DE-A1- 102017 005 562
- DE-B4- 102010 022 611
- US-A1- 2005 237 054
- US-A1- 2016 265 941
- HODGES M P P ET AL: "Suppression of stochastic pinning in magnetic nanowire devices using "virtual" doma", JOURNAL OF APPLIED PHYSICS, AMERICAN INSTITUTE OF PHYSICS, 2 HUNTINGTON QUADRANGLE, MELVILLE, NY 11747, vol. 116, no. 12, 28 September 2014 (2014-09-28), XP012190550, ISSN: 0021-8979, [retrieved on 19010101], DOI: 10.1063/1.4896356
- MA XIAO-PING ET AL: "Suppression of Walker breakdown in gapped magnetic nanowires", JOURNAL OF APPLIED PHYSICS, AMERICAN INSTITUTE OF PHYSICS, 2 HUNTINGTON QUADRANGLE, MELVILLE, NY 11747, vol. 124, no. 8, 28 August 2018 (2018-08-28), XP012231156, ISSN: 0021-8979, [retrieved on 20180828], DOI: 10.1063/1.5038128

## Beschreibung

Die Erfindung betrifft Umdrehungszähler unter Verwendung magnetischer Domänenwandleitbahnen, die schleifenartig verwunden und in sich geschlossen ausgeführt sind, welche insbesondere bei Umdrehungszählern für größere Umdrehungszahlen U (U > 100) eingesetzt werden sollen.

Magnetische Sensoren können Eigenschaften eines magnetischen Feldes, wie z.B. deren Feldrichtung, detektieren. Ein Beispiel dafür ist ein Winkelsensor. Andere Arten von magnetischen Sensoren können bestimmen, wie oft sich ein Magnetfeld gedreht hat Derartige Umdrehungszähler können beispielsweise durch einen GMR-Umdrehungszähler oder einen TMR-Umdrehungszähler gebildet sein, wie sie hinlänglich bekannter Stand der Technik sind (z.B.: RSM-2800: https://www.novotechnik.de/fileadmin/user_upload/pdfs/kataloge_flyer/ Flyer_RSM-2800.pdf). Das Grundprinzip derartiger magnetischer Umdrehungszähler basiert auf der Verwendung von magnetischen Domänenwänden, die sich in durchgehenden magnetischen Bereichen, die man als magnetischer Leiter betrachten kann, bewegen. Sie bestehen aus weichmagnetischen metallischen Materialien. Das Ausleseprinzip verwendet magnetoresitive Effekte. Dazu sind, zumindest lokal, weitere magnetische und nichtmagnetische Schichten notwendig, die es erlauben, die magnetischen Domänenwände zu lokalisieren. Technisch realisiert sind derartige Umdrehungszähler, bei denen in einem elektrisch und magnetisch durchgehenden magnetischen Leiter, der selbst Bestandteil eines GMR-Stacks ist oder lokal einen TMR-Stack bildet, magnetische Domänenwände, aufgrund sich von außen einwirkender magnetischer Felder, generiert, z.B. durch sich drehende Permanentmagnete, innerhalb eines spiralförmig angeordneten magnetischen Leiters bewegen. Die Länge des magnetischen Leiters nimmt dabei überproportional zur Anzahl N der Windungen, aus denen die Spirale besteht, zu, da die Länge jeder einzelnen Windung nach außen ansteigt. Beträgt die Länge der innersten Schleife L₁ und der Abstand der einzelnen Windungen voneinander a, so ergibt sich die Länge Lᵢ der i-ten Windung einer aus N Windungen bestehenden Spiralen, nach folgender Formel zu: Länge L(i)= L₁ + 8(i-1) - a. Damit ergibt sich die Gesamtlänge L(N) einer Spirale mit N Windungen als Summe der Einzellängen Lᵢ zu L(N)=N · L₁ + 4 · a · (N²-N). Diese Länge L(N) steigt also mit N stärker als linear an.

Mit wachsender Länge des durchgehenden magnetischen Leiters steigt proportional die Wahrscheinlichkeit, dass ein Defekt in dem Leiter vorhanden ist, der die Bewegung der magnetischen Domänenwände so behindert, dass seine Funktion nicht mehr erfüllt wird. Damit sinkt mit Erhöhung von N die Ausbeute überproportional. Zugleich wird die benötigte Chipfläche mit wachsendem N immer größer, vor allem bedingt durch die Anzahl der für das Auslesen benötigten Kontaktstellen, deren Anzahl direkt proportional mit N ansteigt. Diese Eigenschaften beschränken die Verwendung einer in sich nicht geschlossenen Spirale für die Realisierung eines Umdrehungszählers in der Praxis auf N <= 64. In der Technik gibt es viele Anforderungen, bei denen deutlich mehr als 64 Umdrehungen gezählt werden müssen, was mit dem vorstehend beschriebenen Grundprinzip nicht erreicht werden kann.

Wie in DE 10 2013 018 680 A1 vorgeschlagen kann die Umdrehungszählung auch so realisiert werden, dass im Gegensatz zur Verwendung nur einer offenen Spirale mehrere geschlossene Schleifen CLᵢ (CL = closed loops) verwendet werden, wobei die i-te Schleife aus einer Spirale mit Nᵢ Windungen besteht. Bei allen Spiralen Nᵢ ist das äußere und innere Ende jeweils miteinander verbunden und bildet somit jeweils eine geschlossene Schleife CLᵢ. Zusätzlich sind die Schleifen Nᵢ mit i = 1.. 4 gemäß Patent DE 10 2013 018 680 A1 jeweils zueinander teilerfremd ausgeführt. Dies erlaubt es, dass ein derart ausgebildeter Umdrehungszähler von 1 bis N₁·N₂·...Nₙ zählen kann. In einem beispielhaften Fall bedeutet dies für n=vier Schleifen mit Nᵢ = 5; 7; 9 und 13, dass Umdrehungszahlen bis 4095 ermittelt werden können. Die Gesamtlänge aller geschlossenen Schleifen entspricht dabei einer einzelnen Spirale, gemäß der vorstehend beschriebenen Lösung mit N=34.

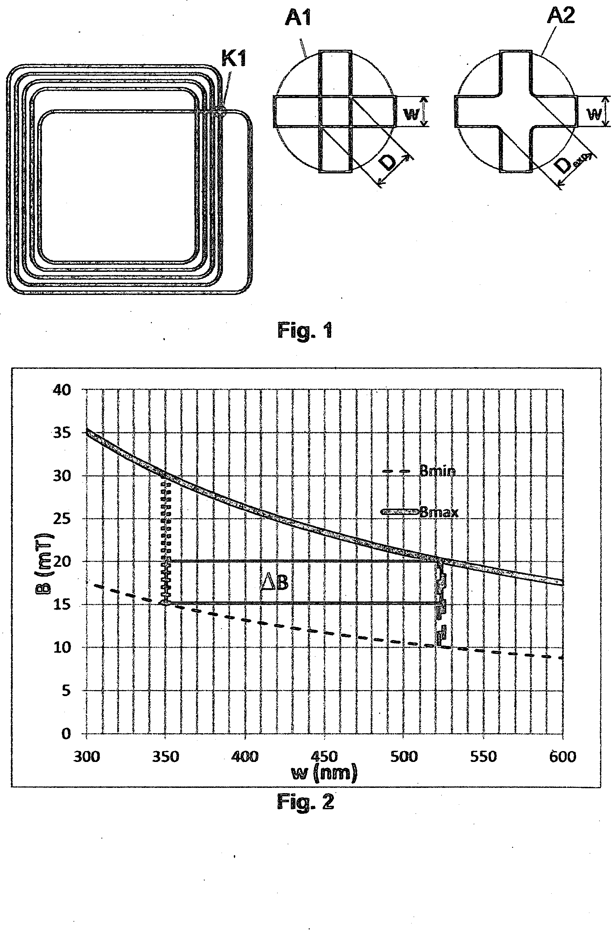

Damit wird deutlich, dass wegen der deutlich kleineren Gesamtanzahl der einzelnen Schleifen in jeder der Schleifen CLᵢ die Gesamtlänge aller Schleifen auch viel kürzer ausgeführt werden kann. Das bedeutet zugleich, dass für eine derartige Realisierung eines Umdrehungszählers die Gesamtlänge der magnetischen Leitbahn, welche die Ausbeute bestimmt, deutlich kürzer ist. Zugleich wird bei diesem Vorschlag auch die Anzahl der für das Auslesen der jeweiligen Umdrehungsinformation nötigen Anschlusspads reduziert. Dies hat des Weiteren zur Folge, dass dieser Umdrehungszähler flächenmäßig kleiner gehalten und damit kostengünstiger hergestellt werden kann. Zur Realisierung der geschlossenen Schleifen CLᵢ müssen die inneren und äußeren Enden aller Schleifen CLᵢ jeweils miteinander verbunden sein. Dafür gibt es im Stand der Technik zwei beschriebene Ansätze. In DE 10 2013 018 680 A1 wird dazu vorgeschlagen, die Verbindung dadurch zu realisieren, dass man, wie in Fig. 1 gezeigt, ein neues funktionelles Element einführt, nämlich eine Kreuzung innerhalb der magnetischen Leitbahn.

Für diese Lösung befindet sich der gesamte Umdrehungssensor auf einer Ebene. Diese Lösung hat den Vorteil, dass mit demselben Technologieschritt, mit dem die Spirale erzeugt wird, auch die Kreuzung hergestellt werden kann. Nachteil dieses Lösungsvorschlages ist es jedoch, dass im Bereich der Kreuzung die Breite der magnetischen Leitbahn mindestens auf den 1.414-fachen Wert (Diagonale D der beiden Stege mit der Breite w, die den Kreuzungsbereich in Fig. 1 bilden) ansteigt und damit innerhalb der Struktur den Wertebereich von w bis Dₑₓₚ annimmt. Wichtige Eigenschaften des Sensors, nämlich der Feldbereich, in dem er fehlerfrei zählen kann, sind direkt mit der Geometrie verknüpft. Für die fehlerfreie Funktionalität gibt es ein Mindestfeld Bₘᵢₙ, das nicht unterschritten werden darf, um die Domänenwände immer sicher in den Domänenwandleitbahnen zu transportieren. Desgleichen darf ein Feld Bₘₐₓ nicht überschritten werden, da sonst innerhalb der Struktur unkontrolliert weitere Domänenwände entstehen. Da die Werte für Bₘᵢₙ und Bₘₐₓ indirekt proportional zur Breite w sind, führt dies an der Kreuzung mit dem um den Faktor 1.42 erhöhten Wert der Breite zu einer lokalen Erniedrigung der Werte für die Minimalinduktion Bₘᵢₙ und die Maximalinduktion Bₘₐₓ, bei denen der Umdrehungssensor betrieben werden kann. Dies ist in Fig. 2 verdeutlicht. Dort ist dargestellt, wie groß das magnetische Fenster ΔB in Abhängigkeit von der Streifenbreite w ist. Für eine Spirale mit der Streifenbreite w=350 nm ist das magnetische Fenster ΔB durch die punktierte Doppellinie in Fig. 2 markiert. Wächst w auf 525 nm ist das magnetische Fenster ΔB durch die senkrechte Doppelstrichlinie charakterisiert. Da in der Spirale mit einer Kreuzung Strukturen mit w=350 nm und mit w= 525 nm vorliegen, ergibt sich das magnetische Fenster ΔB, wie in Fig. 2 gezeichnet, als vertikaler Abstand zwischen den beiden parallelen waagerechten Linien. Daraus folgt, dass ein Umdrehungssensor mit Kreuzung nur innerhalb des in Fig. 2 dargestellten deutlich schmaleren *Δ*B-Bereich betrieben werden kann, der durch den kleineren Wert von Bₘₐₓ sowie den größeren Wert von Bₘᵢₙ der beiden Teilstrukturen gebildet wird.

Die Differenz zwischen Bₘᵢₙ und Bₘₐₓ stellt die Breite des magnetischen Fensters dar, in dem der Umdrehungszähler genutzt werden kann. In dem in Fig. 2 dargestellten Fall würde sich das magnetische Fenster ΔB von einer Breite von 15 mT (eine offene Spirale mit einem b=350 nm) auf eine Breite von knapp 5 mT reduzieren, wenn es gelänge, eine Kreuzung mit einer Diagonale D von 525 nm zu realisieren. Dann wäre das magnetische Fenster, wie in Fig. 2 mit Hilfe des Rechteckes dargestellt, begrenzt durch den Bₘₐₓ-Wert für D=w=525 nm und den Bₘᵢₙ-Wert für w=350 nm und gegenüber der Spirale ohne Kreuzung von 15 mT auf den Wert von 5 mT abgesenkt. Bei den bekannten realisierten Schleifen weicht, wie in Fig. 1 dargestellt, die Geometrie der Kreuzung (vgl. Fig. 1, Kreis A2) von der idealen Geometrie (Kreis A1) ab. Durch die Verrundung an den Kreuzungen vergrößert sich der Wert von D. Mit dem größeren Wert Dₑₓₚ gegenüber dem Wert D der idealen Kreuzung ist das experimentell erreichbare magnetische Fenster mit einer Größe von 1 - 2 mT noch kleiner als man es nach Fig. 2 mit 5 mT erwarten könnte und deshalb für eine praktische Anwendung völlig ungeeignet.

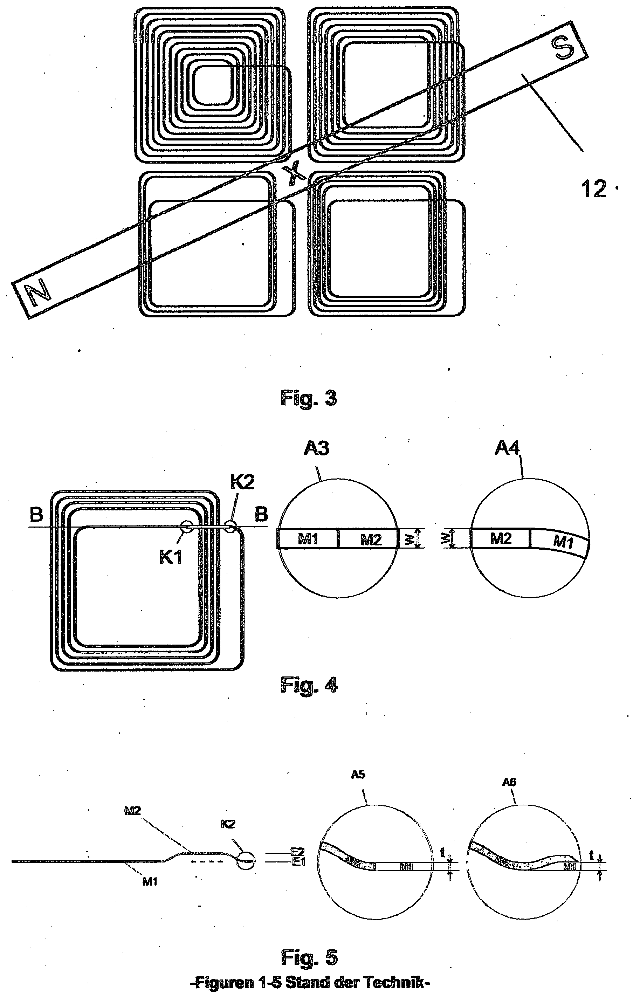

Das magnetische Fenster sollte aus anwendungstechnologischen Gründen möglichst groß sein, da dieses Fenster darüber entscheidet, welche Störfeldfestigkeit der Sensor aufweist. Ein schmales magnetisches Fenster bedingt einen zusätzlichen großen technischen, hier nicht näher beschriebenen Aufwand zur Unterdrückung nichtzulässiger magnetischer Störfelder und damit hohe Kosten und größere Bauformen des Sensorsystems. Zugleich erfordert ein schmales magnetisches Fenster enge Toleranzen bei der Herstellung des Umdrehungszählers bzgl. Einbaulage und auch enge Toleranzen bei dem das Drehfeld generierenden Magneten 12, wie es in Fig. 3 für einen möglichen Anwendungsfall dargestellt ist, was wiederum zu steigenden Kosten führt.

Weiterhin wurde eine kreuzungsfreie geschlossene Schleifenstruktur im Patent DE 10 2010 022 611 B4 vorgeschlagen. Diese Lösung erfordert, dass der Kurzschluss der Spirale, das heißt die Verbindung des inneren mit dem äußeren Ende der Spirale durch einen magnetischen Leiter, so ausgeführt wird, dass keine Kreuzung entsteht. Das kann nur so realisiert werden, dass diese Verbindung in einer Ebene E2 ober- oder unterhalb der Ebene E1 realisiert wird, in dem sich die nicht geschlossene Spirale befindet (vgl. Fig. 4 und 5). Wenn im Idealfall die Breite des magnetischen Leiters überall konstant ist hätte diese Version des Umdrehungszählers mit geschlossenen Schleifen das gleiche breite magnetische Fenster wie die Spirale und würde deshalb ein deutlich breiteres magnetisches Fenster ergeben, als es mit der vorstehend beschriebenen Kreuzungsvariante prinzipiell möglich ist. Bisher gibt es allerdings keine bekannte technische Umsetzung letzt genannter Lösung. Das liegt darin, dass dieser Lösungsvorschlag voraussetzt, dass man die in der Ebene 1 hergestellte noch offenen Spirale, wie es in Fig. 4 in Draufsicht und in Fig. 5 im Querschnitt dargestellt ist, mit einem von der Ebene 1 über die Ebene 2 zurück in die Ebene 1 verlaufenden zusätzlichen magnetischen Leiter M2, vorsehen muss, der die beiden Enden der sich in Ebene 1 befindlichen offenen Spirale an den bezeichneten Stellen K1 und K2 miteinander verbindet.

Die Dicke der für die Bewegung der magnetischen Domänenwände verantwortlichen Schichtstruktur (die Domänenwandleitbahn) beträgt t. Der Querschnitt links in Fig.5 zeigt, dass sich der mit M2 markierte Verbindungsbereich partiell in einer Ebene E2 ober-, oder bei einer ebenso möglichen Lösung, unterhalb der Ebene E1 befindet, in der die zu überquerende Spirale liegt und diese damit nicht berührt. Nur an den Stellen K1 und K2, an denen M2 auf M1 trifft, befinden sich die beiden Strukturen auf einer gemeinsamen Ebene E1.

Die Herausforderung dieses Lösungsansatzes besteht darin, dass erstens der Kurzschluss idealerweise so ausgebildet werden muss, dass der Querschnitt des den Kurzschluss bildenden magnetischen Leiters M2 identisch ist zum Querschnitt des magnetischen Leiters M1 der Spirale. Dies wäre fertigungstechnisch noch vergleichsweise einfach zu realisieren. Besonders kritisch bei diesem Lösungsansatz ist die Stelle, an der der magnetische Leiter M1 und der magnetische Leiter M2 aufeinandertreffen. Dies muss lateral und vertikal praktisch versatzfrei erfolgen, da, wie gefunden wurde, schon Verschiebungen quer zum Steifen im Bereich von 15 nm ein Festhalten (Pinnen) der sich bewegenden magnetischen Domänenwände stark befördern und damit den Wert des in Fig. 2 dargestellten unteren magnetischen Fensters Bₘᵢₙ erhöhen würde. Deshalb muss der laterale Versatz, um z.B. das untere magnetische Fenster nicht merklich zu verschlechtern, kleiner 1/20 der Breite des magnetischen Leiters betragen, die bei den bisher genutzten Sensoren bei ca. 350 nm liegt Noch kritischer ist die Forderung, dass auch die Dicke an der Stelle, an der beide Leiter M2 und M1 direkt aneinander stoßen, nur minimal unterschiedlich sein darf zur Dicke der aneinander anschließenden Leitbahnabschnitte M1 und M2, um einen durchgehenden magnetischen Leiter zu erhalten, der auf der gesamten Länge die gleichen für die Sensorfunktion entscheidenden Eigenschaften für das Entstehen der magnetischen Domänenwände sowie auch ihrer Bewegung durch den magnetischen Leiter hat. Diese Forderung schließt jedoch eine denkbare Überlappung an der Verbindungsstelle, wie sie im vergrößerten Kreis A6 in Fig. 5 dargestellt ist, aus.

Die Figuren 1 bis 5 repräsentieren Lösungen nach dem bekannten Stand der Technik und die sich danach ergebenden Probleme.

Der Erfindung liegt die Aufgabe zugrunde, einen Umdrehungszähler unter Verwendung magnetischer Domänenwandleitbahnen, die schleifenartig angeordnet und im Wesentlichen in einer Ebene liegend und geschlossen ausgeführt sind, anzugeben, der die Nachteile der geschilderten Lösungen des Standes der Technik nicht oder nur in viel geringerem Maße aufweist, insbesondere soll er technologisch handhabbar sein und ein möglichst großes magnetisches Fenster aufweisen.

Die Erfindung wird durch die Kennzeichen des ersten Patentanspruchs gelöst, wobei der Verbindungsbereich, in dem die inneren und äußeren Schleifenabschnittsenden einer Schleife einer ersten magnetischen Domänerrwandleitbahn M1 zusammengeführt sind, von einer zweiten magnetischen Domänenwandleitbahn M2 überbrückt ist, deren Anbindung an die magnetischen Domänenwandleitbahnenden der Spirale über je einen Spalt 201 erfolgt, wobei durch den Spalt 201 eine lokale Unterbrechung der zu schließenden Domänenwandleitbahn M1 geschaffen ist, wobei diesem Spalt 201 eine solche Breite gegeben ist, dass bei einer Bewegung einer Domänenwand DW von einem ersten Domänenleitbahnabschnitt (M2 oder M1) in diesem ein Streufeld erzeugt und in Bewegungsrichtung nach dem Spalt 201 im anschließenden Domänenleitbahnabschnitt (M2 oder M1) zu einer Nukleation einer Domänenwand DW führt, wobei die mittlere Breite des Spalts 201 kleiner als die Dicke t der Domänenwandleitbahn M1 festgelegt ist und die angrenzenden Domänenleitbahnabschnitte (M2 oder M1), im Spaltbereich von einer nichtmagnetischen Schicht S1 erfasst sind.

Vorteilhafte Ausgestaltungen sind Gegenstand der nachgeordneten Ansprüche.

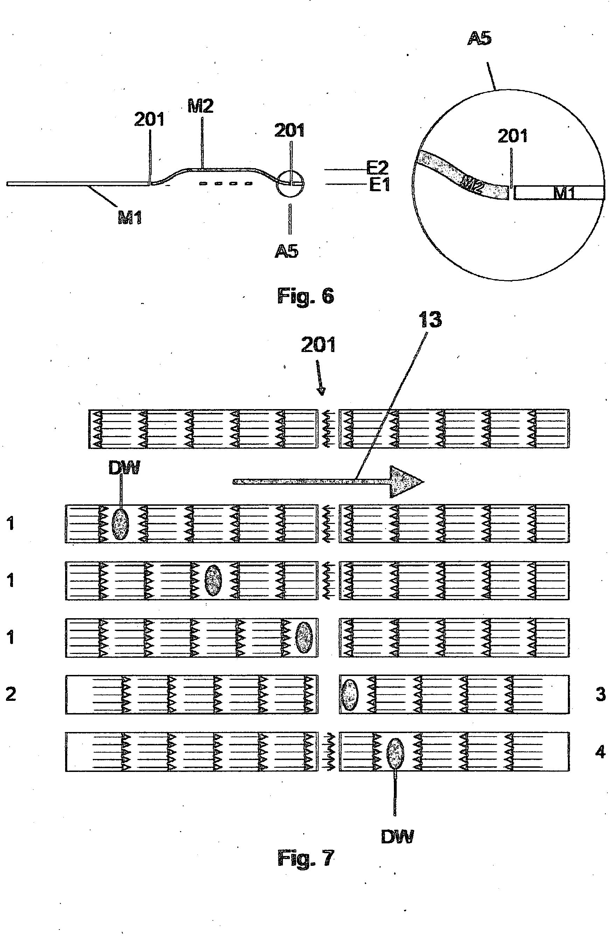

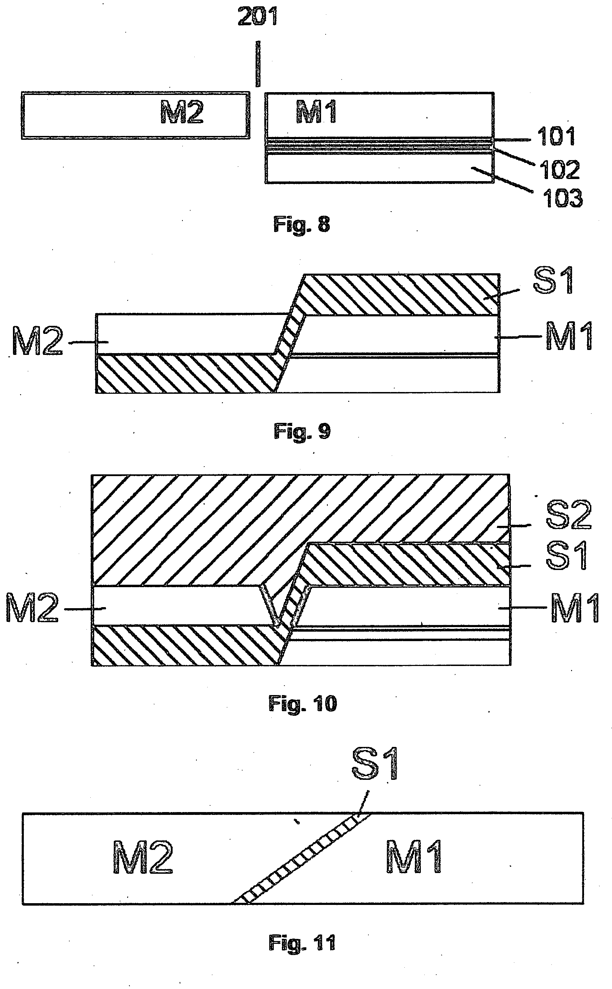

Das Wesen der Erfindung besteht dabei darin, die magnetische Leitbahn, in der sich die magnetischen Domänenwände bewegen, nicht als kontinuierliche, durchgehende Leitbahn, wie nach dem Stand der Technik üblich, auszubilden, sondern so, wie in den Figuren 6 bis 14 dargestellt. Insbesondere an den Übergangsstellen jeweils von der Domänenwandleitbahn M1 zu M2 soll ein schmaler Spalt 201 erfindungsgemäß vorgesehen sein, der z.B. mit nichtmagnetischem Material gefüllt sein kann, wie es in den Figuren 9 bis 11 beispielhaft angedeutet ist. Mit der Unterbrechung des magnetischen Leiters ergeben sich, wie gefunden wurde, überraschender Weise Vorteile, die zu einer Verbesserung der magnetischen Eigenschaften des Umdrehungszählers im Vergleich zu den bisher bekannten Lösungen führen. Wie in durchgeführten mikromagnetischen Simulationsrechnungen gefunden wurde, stellt ein nicht zu großer Spalt 201 innerhalb des magnetischen Leiters unerwartet kein Hindernis für die Funktionalität des Sensors dar. Wie die Bewegung einer magnetischen Domänenwand DW über den erfindungsgemäßen Spalt hinweg stattfindet, ist in Fig. 7 verdeutlicht.

Die Bildersequenz in Fig. 7 zeigt schematisch die Magnetisierungsverteilung in M1 und M2 bei einem Durchgang einer Domänenwand durch den Spalt 201 in Draufsicht. Das oberste Bild zeigt die Ausgangskonfiguration. Die Magnetisierung in beiden Bereichen M1 und M2 zeigt nach links. Der schmale Spalt 201 zwischen M1 und M2 ist durch ein Streufeld erfasst, das von dem rechten zum linken Leiter verläuft.

Wirkt auf diese Anordnung mit einer Domänenwand DW im linken Leiter M1 ein homogenes, im Wesentlichen nach rechts zeigendes Feld, repräsentiert durch den fetten Pfeil 13 (erzeugt durch den in Fig. 3 dargestellten äußeren Magneten 12), wird die Domänenwand DW innerhalb des linken Leiters M1 nach rechts bewegt. Alle mit (1) in Fig. 7 markierten Teilabbildungen beschreiben eine Bewegung der Domänenwand im Leiter M1. Die Domänenwand bewegt sich unter Einwirkung eines hinreichend großen Magnetfeldes in Richtung des Spalts 201. Dort verschwindet sie auf der rechten Seite des linken Leiters (mit (2) markiert), was zu einer Änderung des Streufeldes im Spalt führt. Gemeinsam mit dem äußeren Feld, erzeugt durch den in Fig. 3 dargestellten Permanentmagneten 12 und in der Figur 7 repräsentiert durch den fetten Pfeil, führt das geänderte Streufeld zu einer Nukleation einer Domänenwand DW (mit (3) markiert) am linken Rand des rechten Leiters M2. Diese Domänenwand bewegt sich unter dem Einfluss des Feldes (mit (4) markiert) im rechten Leiter weiter nach rechts.

Das Verschwinden der Domänenwand auf der einen Seite und die Nukleation auf der anderen Seite verhindert ein Festhalten der Domänenwand, wie man es bei einem durchgehenden magnetischen Leiter, gemäß des oben beschriebenen Standes der Technik, an einer realen Übergangsstelle zwischen M1 und M2 ohne Spalt beobachten würde.

Zur detaillierten Erläuterung der Erfindung sollen nachfolgende Ausführungsbeispiele dienen. Es zeigen:
- Fig. 1: eine Draufsicht auf eine Spirale, bei der das innere und äußere Ende in der Ebene der Spirale verbunden sind, die Kreuzung K1 ist rechts zweimal vergrößert dargestellt. In A1 sind die idealisierten Verhältnisse der Kreuzungsgeometrie dargestellt. A2 zeigt den Zustand, den man mit optischer Lithographie üblicherweise erreichen kann und die zu einem vergrößerten Kreuzungsbereich (Diagonale Dₑₓₚ) führt;
- Fig. 2: eine Darstellung der Abhängigkeit des oberen und unteren magnetischen Fensters (Bₘₐₓ(w) fette schwarz Kurve und Bₘᵢₙ(w) dünne schwarze strichlinierte Kurve) in Abhängigkeit von der Breite w der Domänenwandleitbahn, in denen sich die magnetischen Domänen bewegen. Waagerechten Striche begrenzen den ΔB-Bereich im Falle der geschlossenen Spirale mit Kreuzung bei einer Stegbreite von 350 nm und einer Diagonale der Kreuzung von 525 nm;
- Fig. 3: eine Draufsicht auf die schematische Darstellung eines Umdrehungszählers (ohne Darstellung der Kontakte) mit vier geschlossenen Spiralen für die Zählung von 3; 5; 7 und 11 Umdrehungen, der in der Lage ist, bis 1155 Umdrehungen zu zählen. Ober- oder unterhalb der geschlossenen Spiralen befindet sich ein um die Drehachse X drehender Permanentmagnet 12, dessen Streufeld alle 4 geschlossenen Spiralen erfasst;
- Fig. 4: eine Draufsicht auf eine Spirale für die Zählung von fünf Umdrehungen, die durch den Bereich M2 geschlossen wird. Rechts sind die im linken Bild markierten kreisförmigen Bereiche vergrößert dargestellt;
- Fig. 5: einen Querschnitt in B-B-Richtung von Fig. 4. Rechts ist der im linken Bild als K2 markierte kreisförmige Bereich in zwei Versionen (A5 idealisierte Variante und A6 überlappende Variante) vergrößert dargestellt;

Die Figuren 1 bis 5 stellen den bekannten oder denkbaren Stand der Technik dar.
- Fig. 6: einen Querschnitt der Domänenwandleitbahn mit einem erfindungsgemäßen Spalt 201 jeweils zwischen M1 und M2, rechts ist im Ausschnitt A5 ein Übergang zwischen M2 und M1 mit Spalt dazwischen vergrößert dargestellt;
- Fig. 7: Sequenzen der Bewegung einer Domänenwand DW von einer Seite des magnetischen Leiter M1 über den erfindungsgemäßen Spalt 201 hinweg zum anderen magnetischen Leiter M2. Die Position der Domänenwand DW ist schematisch durch eine schwarze Ellipse dargestellt, die Richtung der Magnetisierung innerhalb der magnetischen Leitbahnen M1 und M2 durch schwarze Pfeile. Der dicke Pfeil repräsentiert das vom Permanentmagneten 12 auf die Struktur einwirkende Magnetfeld;
- Fig. 8: einen Querschnitt der Verbindungsstelle M1 zu M2 mit Spalt 201, wobei rechts ein kompletter XMR-Stack (GMR oder TMR-) dargestellt ist mit M1 als magnetischer Leitbahn, darunter eine Trennschicht 101 (z.B.: 2 nm Cu für einen GMR-Stack und ∼ 1nm Isolator für einen TMR-Stack), darunter ein sogenannter künstlicher Antiferromagnet 102, bestehend aus CoFe/Ru/CoFe sowie einem Antiferromagneten 103;
- Fig. 9: einen Querschnitt einer Ausbildung der Kontaktstelle, bei der die Kanten der Schichten M1 und M2 schräg ausgebildet und durch eine Trennschicht S1 voneinander geometrisch beabstandet sind;
- Fig. 10: einen Querschnitt einer Ausbildung der Kontaktstelle zwischen M1 und M2 mit Spalt dazwischen, bei der die Kanten der Schichten M1 und M2 schräg, und V-förmig ausgebildet (vgl. fett
- Fig. 11: markierte Schrägen) und durch eine Trennschicht S1 und S2 voneinander geometrisch beabstandet sind. eine Draufsicht einer Ausbildung der Kontaktstelle, bei der die Kanten der Schichten M1 und M2 schräg ausgebildet und durch eine Trennschicht S1 voneinander geometrisch beabstandet sind;
- Fig. 12: einen Querschnitt der Kontaktstelle, bei dem ein vertikaler Versatz der Größe vs der beiden Domänenwandleitbahnen dargestellt ist;
- Fig. 13: eine Draufsicht auf die Verbindung, bei dem ein lateraler, horizontaler Versatz hs der beiden Domänenwandleitbahnen dargestellt ist und
- Fig. 14: eine Draufsicht auf eine Verbindung, bei dem für M1 und M2 Materialien mit unterschiedlicher Sättigungsmagnetisierung Mₛ⁽¹⁾ und Mₛ⁽²⁾ verwendet werden.

Die Figuren 1 bis 5 stellen den bekannten oder denkbaren Stand der Technik dar, der in der Einleitung mit den damit verbundenen Nachteilen bereits hinreichend beschrieben wurde.

Ab Fig. 6 setzt eine detaillierte Beschreibung vorliegender Erfindung ein. Dabei zeigt Fig. 6 einen Ausschnitt des Querschnitts der Domänenwandleitbahn mit einem erfindungsgemäßen Spalt 201 jeweils zwischen den Domänenleitbahnabschnitten M1 und M2. Rechts ist im Ausschnitt A5 ein Übergang zwischen M2 und M1 mit dem Spalt 201 dazwischen vergrößert dargestellt.

Wie die Fortleitung einer Domänenwand DW in den beiden magnetischen Leitbahnabschnitten und über den Spalt 201 erfolgt, zeigt Figur 7 im Detail. Die Position der Domänenwand DW ist schematisch durch eine schwarze Ellipse dargestellt, die Richtung der Magnetisierung innerhalb der magnetischen Domänenwandleitbahnen M1 und M2 durch schwarze Pfeile. Der dicke Pfeil repräsentiert das vom Permanentmagneten 12 (vgl. Fig. 3) auf die Struktur einwirkende Magnetfeld. Wie der Domänenwandtransport über den erfindungsgemäßen Spalt 201 im Detail erfolgt, wurde weiter oben bereits eingehend beschrieben.

Figur 8 zeigt im rechten Teil einen typischen Aufbau, wie er für einen GMR- oder TMR-Stack verwendet wird und bekannt ist. Die Schicht 103 bezeichnet eine antiferromagnetische Schicht, z.B. PtMn, die darauf liegende Schicht 102 einen künstlichen Antiferromagneten AAF (artificial antiferomagnetic layer). Dies ist ein Schichtsystem, das als künstlicher Antiferromagnet bekannt ist und typischerweise einen Aufbau CoFe/0.8 nm Ru/ CoFe aufweist. Die Schicht M1 ist die Schicht, in der sich die magnetischen Domänen innerhalb der genannten Schleife bewegen. Sie ist üblicherweise weichmagnetisch und besteht aus Ni-, Fe- und/oder Co-Legierungen wie z.B. Ni₈₁Fe₁₉, NiFeCo, NiFeB, CoFe, CoFeB oder Kombinationen dieser Materialien. Gemäß vorliegender Erfindung besteht nun die Maßgabe, dass die Schicht M1 nicht direkt mit der Schicht bzw. dem Schichtstapel, der M2 bildet, verbunden ist.

Figur 9 zeigt ein Beispiel, bei dem die Schicht M1 und die Schicht M2 durch eine schraffiert dargestellte nichtmagnetische Trennschicht S1 separiert ist. Erfindungsgemäß besteht diese Schicht aus nichtmagnetischem Material und kann sowohl elektrisch leitend, halbleitend als auch isolierend sein. Dies erlaubt eine große Variabilität für die technologische Umsetzung. Dabei zeigt Fig. 9 die Kontaktstelle, bei der die Kanten der Schichten M1 und M2 schräg, aber parallel zueinander ausgebildet und durch eine Trennschicht S1 voneinander geometrisch beabstandet sind.

Wie Figur 10 zeigt, muss der laterale Abstand zwischen M1 und M2 im Rahmen vorliegender Erfindung nicht konstant sein, sondern kann, wie im Falle des dort dargestellten V-förmigen Spaltes auch variieren. Bei dieser technischen Lösung sind beide Bereiche in vertikaler Richtung abgeschrägt, durch eine Separationsschicht S1 mit einem Mindestanstand versehen und anschließend mit einer Separationslayer S2 bedeckt, die den Spalt komplett füllt. Auch für diese Lösung gilt, dass die beiden Separationlayer S1 und S2 aus beliebigen nichtmagnetischen Materialien bestehen. Nichtmagnetisch bedeutet, sie dürfen kein magnetisches Permanentmoment aufweisen, also weder ferromagnetisch noch ferrimagnetisch sein. Das heißt, dass diese Materialien diamagnetisch, paramagnetisch oder antiferromagnetisch sein müssen.

Der Spalt, der sich zwischen M1 und M2 befindet, kann aber auch in der Ebene schräg angeordnet sein, wie es in Fig. 11 als Draufsicht auf die Domänenwandleitbahnen beispielhaft dargestellt ist. Ebenso liegen Kombinationen verschiedener vorstehend beschriebener Ausführungen der Spaltgeometrie im Rahmen der Erfindung.

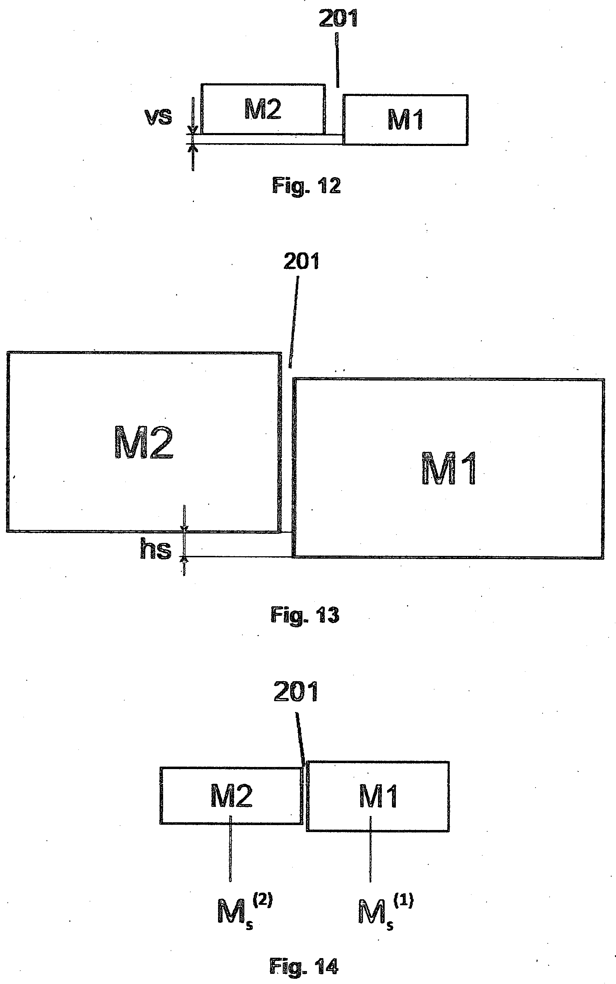

Für die technologische Umsetzung von großem Vorteil ist, dass es die erfindungsgemäße Lösung gestattet, dass die Querschnitte von M1 und M2 nicht exakt ineinander übergehen müssen, sondern sowohl lateral als auch vertikal leicht versetzt sein können, wie in Fig. 12 und 13 beispielhaft angedeutet.

Fig. 12 zeigt als Beispiel den Querschnitt der Kontaktstelle, bei dem ein vertikaler Versatz der Größe vs erlaubt ist. Solange der vertikale Versatz vs unterhalb 25% der Dicke t der Domänenwandleitbahn M1 liegt, also bei einer typischen Dicke der weichmagnetischen Schicht von 40 nm unterhalb 10 nm ist, kann die magnetische Domänenwand, wie in Fig. 7 schematisch dargestellt, diesen Spalt überspringen. Gleiches gilt für einen lateralen Versatz hs der beiden Strukturen M1 und M2, wie er in Fig. 13 dargestellt ist. Solange der laterale Versatz hs unterhalt 25% der Breite der Domänenwandleitbahn liegt, also bei einem typischen System 360 nm unterhalb 90 nm ist, kann die magnetische Domänenwand den Spalt zwischen M1 und M2 analog wie vorstehend beschrieben überspringen.

Die vorgeschlagene Lösung bietet noch weitere technologische Freiheitsgrade, von denen beispielhaft in Fig. 14 eine Lösung dargestellt ist, bei der der Wert der Sättigungsmagnetisierung der beiden Bereiche M1 und M2 unterschiedlich ist. Für das Funktionieren der Bewegung der magnetischen Domänenwand durch den erfindungsgemäßen Spalt ist nämlich der magnetische Fluss, welcher von M1 auf M2 und von M2 auf M1 wirkt, entscheidend. Das bedeutet, das Produkt aus Querschnitt mal Sättigungsmagnetisierung Mₛ sollte in etwa gleich sein. So kann z.B. für die Ausbildung des Domänenwandleitbahnbereichs M2 ein Material mit einem um 40% größeren Wert der Sättigungsmagnetisierung Mₛ⁽²⁾ gegenüber dem Wert der Sättigungsmagnetisierung Mₛ⁽¹⁾ verwendet werden, wenn man den Querschnitt dieses Materials um 40% reduziert. Dies ergibt sich z.B., wenn die Domänenwandleitbahn M1 mit Ni₈₁Fe₁₉ mit einer Sättigungsmagnetisierung von 800kA/m kombiniert wird mit M2 aus CoFe mit einer Sättigungsmagnetisierung von 1140kA/m. Diese Reduzierung kann entweder durch Reduktion der Breite oder der Dicke um 40% erfolgen oder eine Kombination von beiden Änderungen wie z.B. durch Reduzierung der Breite um z.B. 20% und der Dicke um 20%. Bei der Reduzierung der Geometrien Breite und Dicke ist jedoch eine symmetrische Reduzierung einer stark asymmetrischen Reduktion vorzuziehen.

Aus den vorgenommenen mikromagnetischen Simulationen kann man ableiten, dass die erwartbaren Werte für Bₘᵢₙ und Bₘₐₓ nahezu unverändert sind, solange die mittlere Spaltbreite < 50% der Schichtdicke t des magnetischen Leiters beträgt Steigt die mittlere Spaltbreite merklich darüber, ist auch mit einer moderaten Erhöhung für Bₘᵢₙ und moderaten Erniedrigung von Bₘₐₓ zu rechnen. Bei den maximal zugelassenen Änderungen der mittleren Spaltbreite, bezogen auf die Schichtdicke t, sinkt die Breite des magnetischen Fensters von 15 mT auf 10 mT.

Mit der Umsetzung der vorgeschlagenen Erfindung wird eine neuartige Herstellung einer geschlossenen Schleife durch Überbrückung einer in einer Ebene liegenden spiralartigen Anordnung mit einer für die Umdrehungszählung geeigneten bekannten Struktur mit einer in einer zweiten Ebene die Domänenwände tragenden Struktur unter Nutzung einer geometrischen Unterbrechung ermöglicht. Die vorliegende Erfindung bietet für die technologische Umsetzung eine Reihe von bisher nicht zugänglichen Möglichkeiten und führt bei deren erfolgreichen Umsetzung zu einer deutlichen Verbreiterung des magnetischen Fensters im Vergleich zu den bisher bekannten Lösungen nach dem Stand der Technik.

Während bei Übergängen, wie nach dem Stand der Technik üblich (vgl. z.B. DE 10 2010 022 611 B4) bereits bei geringsten Stufen oder Lithografiefehlem in der Größenordnung von 15 nm ein Pinnen von Domänen zu beobachten ist, die zur Funktionsunfähigkeit des Umdrehungszählers führen, hat eine vergleichsweise große Unterbrechung der Domänenwandleitbahn an der Stelle des erfindungsgemäßen Spalts keinerlei negativen Einfluss auf den Domänenwandtransport.

### Bezugszeichenliste

- E1: Ebene, in der die schleifenartigen Domänenwandleitbahnen liegen
- E2: Verbindungsebene
- K1, K2,: Kreuzungsstellen
- A1, A2, A3, A4, A5, A6: Kreise mit vergrößerten Abbildungen
- w: Breite der Domänenwandleitbahn M1
- D: Diagonale einer Kreuzung
- Dₑₓₚ: vergrößerter (realistischer) Wert von D
- X: Drehachse des Permanentmagneten 12
- DW: Domänenwand
- 12: Permanentmagnet
- 13: Pfeil, der Feldrichtung anzeigt
- B-B: Schnittebene
- M1: Domänenwandleitbahn der schleifenartigen Struktur
- M2: zweiten überbrückende Domänenwandleitbahn
- Mₛ⁽¹⁾, Mₛ⁽²⁾: unterschiedliche Sättigungsmagnetisierungen
- t: Dicke der Domänenwandleitbahn M1
- 201: Spalt zwischen M1 und M2
- 101: Trennschicht
- 102: künstlicher Antiferromagnet
- 103: Antiferromagnet
- S1: nichtmagnetische Schicht
- vs: vertikaler Versatz zwischen M1 und M2
- hs: horizontaler Versatz zwischen M1 und M2

## Patentansprüche

1. Umdrehungszähler beinhaltend Domänenwandleitbahnen, die schleifenartig angeordnet und im Wesentlichen in einer Ebene (E1) liegend geschlossen ausgeführt sind, so dass sie eine Spirale bilden, wobei der Verbindungsbereich, in dem die inneren und äußeren Schleifenabschnittsenden einer Schleife einer ersten magnetischen Domänenwandleitbahn (M1) zusammengeführt sind, von einer zweiten magnetischen Domänenwandleitbahn (M2) überbrückt sind, **dadurch gekennzeichnet, dass** deren Anbindung an die magnetischen Domänenwandleitbahnenden der Spirale über je einen Spalt (201) erfolgt, wobei durch den Spalt (201) eine lokale Unterbrechung der zu schließenden Domänenwandleitbahn (M1) geschaffen ist, wobei diesem Spalt (201) eine solche Breite gegeben ist, dass bei einer Bewegung einer Domänenwand (DW) von einem ersten Domänenwandleitbahnabschnitt (M2 oder M1) in diesem ein Streufeld erzeugt und in Bewegungsrichtung nach dem Spalt (201) im anschließenden Domänenwandleitbahnabschnitt (M2 oder M1) zu einer Nukleation einer Domänenwand (DW) führt, wobei die mittlere Breite des Spalts (201) kleiner als die Dicke (t) der Domänenwandleitbahn (M1, M2) festgelegt ist und die angrenzenden Domänenwandleitbahnabschnitte (M2 oder M1), im Spaltbereich von einer nichtmagnetischen Schicht (S1) erfasst sind.

2. Umdrehungszähler nach Anspruch 1, **dadurch gekennzeichnet, dass** die Domänenwandleitbahnabschnitte (M1, M2) zueinander einen horizontalen und/oder vertikalen Versatz (hs, vs) aufweisen dürfen, solange diese Versätze unterhalb 25% der Dicke (t) bzw. der Breite (w) der Domänenwandleitbahn (M1) liegen.

3. Umdrehungszähler nach Anspruch 1, **dadurch gekennzeichnet, dass** die den Spalt (201) bildenden Endflächen der Domänenwandleitbahnen (M1, M2) zueinander parallel und/oder schräg in einem Winkelbereich von 25° bis 90° angeordnet sind.

4. Umdrehungszähler nach Anspruch 2, **dadurch gekennzeichnet, dass** die den Spalt (201) bildenden Endflächen der Domänenwandleitbahnen (M1, M2) zueinander parallel und/oder schräg in einem Winkelbereich von 25° bis 90° angeordnet sind.

5. Umdrehungszähler nach Anspruch 1, **dadurch gekennzeichnet, dass** für die ersten und zweiten Domänenwandleitbahnstrukturen (M1 und M2) weichmagnetische Materialien mit unterschiedlicher Sättigungsmagnetisierung eingesetzt sind, wobei der Unterschied der Sättigungsmagnetisierungen unterhalb von 40% vorteilhaft einzuhalten ist.

6. Umdrehungszähler nach Anspruch 5, **dadurch gekennzeichnet, dass** die Abweichung des Produktes aus Querschnitt und Sättigungsmagnetisierung der beiden weichmagnetischen Bereiche der Domänenwandleitbahnstrukturen (M1 und M2) < 25% beträgt.

7. Umdrehungszähler nach Anspruch 1, **dadurch gekennzeichnet, dass** die nichtmagnetische Schicht (S1) aus einem Material besteht, das diamagnetisch, paramagnetisch oder antiferromagnetisch ist.

## Claims

1. A multiturn counter comprising domain wall conductors which are arranged in the manner of closed loops and are situated substantially in a plane (E1), thus forming a spiral, the connecting region, in which the inner and outer loop section ends of a loop of a first magnetic domain wall conductor (M1) are combined, being bridged by a second magnetic domain wall conductor (M2), **characterized in that** their connection to the magnetic domain wall conductor ends of the spiral is made with a respective gap (201), the gap (201) creating a local interruption of the domain wall conductor (M1) to be closed, this gap (201) being provided with such a width that, during a movement of a domain wall (DW) of a first domain wall conductor section (M2 or M1), a stray field is generated therein and, in the movement direction downstream of the gap (201), results in nucleation of a domain wall (DW) in the subsequent domain wall conductor section (M2 or M1), the mean width of the gap (201) being set to be less than the thickness (t) of the domain wall conductor (M1, M2) and the adjoining domain wall conductor sections (M2 or M1) being encompassed by a non-magnetic layer (S1) in the gap region.

2. The multiturn counter according to claim 1, **characterized in that** domain wall conductor sections (M1, M2) are allowed to have a horizontal and/or vertical offset (hs, vs) with respect to one another as long as these offsets are less than 25% of the thickness (t) or the width (w) of the domain wall conductor (M1).

3. The multiturn counter according to claim 1, **characterized in that** the end faces of the domain wall conductors (M1, M2) forming the gap (201) are disposed parallel to one another and/or obliquely in an angular range of 25° to 90°.

4. The multiturn counter according to claim 2, **characterized in that** the end faces of the domain wall conductors (M1, M2) forming the gap (201) are disposed parallel to one another and/or obliquely in an angular range of 25° to 90°.

5. The multiturn counter according to claim 1, **characterized in that** soft magnetic materials having differing saturation magnetizations are used for the first and second domain wall conductor structures (M1 and M2), the difference in the saturation magnetizations advantageously to be kept below 40%.

6. The multiturn counter according to claim 5, **characterized in that** the deviation of the product of cross-section and saturation magnetization of the two soft magnetic regions of the domain wall conductor structures (M1 and M2) is <25%.

7. The multiturn counter according to claim 1, **characterized in that** the non-magnetic layer (S1) consists of a diamagnetic, paramagnetic or antiferromagnetic material.

## Revendications

1. Compteur multitour comprenant des conducteurs de paroi de domaine, lesquels sont disposés en boucles fermées et se trouvent sensiblement dans un plan (E1), afin de former une spirale, la zone de jonction, où sont réunies les extrémités intérieure et extérieure de la partie de boucle d'une boucle d'un premier conducteur de paroi de domaine (M1), étant pontée par un deuxième conducteur de paroi de domaine magnétique (M2), **caractérisé en ce que** la jonction de ceux-ci aux extrémités des conducteurs de paroi de domaine de la spirale est effectuée par un espacement (201) respectif, l'espacement (201) créant une interruption locale du conducteur de paroi de domaine (M1) à fermer, l'espacement (201) étant pourvu d'une largeur telle que, lors d'un mouvement d'une paroi de domaine (DW) d'une première partie du conducteur de paroi de domaine (M2 ou M1), un champ de dispersion est créé dedans et, dans la direction en aval de l'espacement (201), résulte en une nucléation d'une paroi de domaine (DW) dans la partie du conducteur de paroi de domaine (M2 ou M1) suivante, la largeur moyenne de l'espacement (201) étant définie de façon à être inférieure à l'épaisseur (t) du conducteur de paroi de domaine (M1, M2), les parties du conducteur de paroi de domaine (M2 ou M1) adjacentes dans la zone d'espacement étant englobées d'une couche (S1) amagnétique.

2. Compteur multitour selon la revendication 1, **caractérisé en ce que** les parties du conducteur de paroi de domaine (M1, M2) peuvent présenter un décalage horizontal et/ou vertical (hs, vs) l'une par rapport à l'autre, pourvu que ces décalages soient inférieurs à 25% de l'épaisseur (t) ou de la largeur (w) du conducteur de paroi de domaine (M1).

3. Compteur multitour selon la revendication 1, **caractérisé en ce que** les faces d'extrémité des conducteurs de paroi de domaine (M1, M2) qui forment l'espacement (201) sont disposées parallèlement les unes aux autres et/ou de manière inclinée dans une plage angulaire allant de 25° à 90°.

4. Compteur multitour selon la revendication 2, **caractérisé en ce que** les faces d'extrémité des conducteurs de paroi de domaine (M1, M2) qui forment l'espacement (201) sont disposées parallèlement les unes aux autres et/ou de manière inclinée dans une plage angulaire allant de 25° à 90°.

5. Compteur multitour selon la revendication 1, **caractérisé en ce que** des matériaux magnétiques doux dotés d'une magnétisation de saturation différente sont utilisés pour la première et la deuxième structure de conducteurs de paroi de domaine (M1 et M2), le maintien au-dessous de 40 % de la différence des magnétisations de saturation étant avantageux.

6. Compteur multitour selon la revendication 5, **caractérisé en ce que** la déviation du produit de la coupe transversale et de la magnétisation des deux zones magnétiques douces des structures de conducteurs de paroi de domaine (M1 et M2) est <25%.

7. Compteur multitour selon la revendication 1, **caractérisé en ce que** la couche amagnétique (S1) consiste en un matériau diamagnétique, paramagnétique ou antiferromagnétique.
